# EUROPEAN PATENT SPECIFICATION

(11) **EP 0 413 397 B1**
(45) Date of publication and mention of the grant of the patent: **06.07.1994**
(21) Application number: 90202202.9
(22) Date of filing: 15.08.1990
(51) Int. Cl.: H01L 41/09, G02B 26/02

(54) **Electro-mechanical transducer and positioning device comprising such an electro-mechanical transducer**
Elektromechanischer Wandler und Positionierungseinrichtung mit einem derartigen elektromechanischen Wandler
Transducteur électromécanique et dispositif de positionnement electromécanique

(30) Priority: 18.08.1989 NL 8902094
(43) Date of publication of application: 20.02.1991
(73) Proprietor: Philips Electronics N.V., 5621 BA Eindhoven (NL)
(72) Inventor: Moraal, Hendrik Karel, NL-5656 AA Eindhoven (NL)
(74) Representative: Cuppens, Hubertus Martinus Maria

(56) References cited:
- EP-A- 0 239 085
- US-A- 4 087 715

## Description

The invention relates to an electro-mechanical transducer, comprising a tubular piezo-electric element which is covered with an inner and an outer electrode over a length on an inner side and an outer side, which outer electrode comprises conductor segments which are electrically isolated from one another in a circumferential direction by insulating tracks.

The invention also relates to a positioning device for a relative displacement of two objects with respect to one another, which positioning device comprises an electro-mechanical transducer of the kind set forth.

An electro-mechanical transducer and a positioning device of the kind set forth are known from: G. Binnig and D.P.E. Smith: "Single-tube three-dimensional scanner for scanning tunneling microscopy", Rev. Sci. Instrum. 57(8), August 1986.

The cited article describes an electro-mechanical transducer for use in a scanning tunneling microscope. In a microscope of this kind, a needle connected to the transducer is moved across a surface. Depending on a distance between the needle and the surface, a so-called tunneling current flows between the surface and the needle. By holding the needle, by way of the transducer, at a distance above the surface for which the tunneling current is constant, a variation of the transducer in length produces a measure of the topography of the surface. The transducer is formed by a tubular element of a piezo-electric material which is polarized so that an electric field perpendicular to the longitudinal direction causes a length variation. The element is covered with an electrode on its inner and outer sides. The outer electrode is sub-divided into four conductor segments which are electrically isolated from one another by insulating tracks extending in the longitudinal direction. Under the influence of a voltage across the conductor segments and the inner electrode, the length of the piezo-electric material situated underneath the relevant conductor segment is varied. The outer conductor segments are situated pairwise opposite one another, an angle between neighbouring outer conductor segments amounting to 90°. By supplying, for example oppositely situated conductor segments with an opposite voltage with respect to the inner electrode, the element is bent under the influence of a reduction of the length of the piezo-electric material underneath one conductor segment and an increase of the length of the piezo-electric material underneath the other conductor segment. Thus, an object connected to the transducer can be displaced in a radial plane in mutually perpendicular directions (an x-direction and an y-direction). By applying a voltage to the inner electrode, a length variation takes place which is uniform over the circumference of the element, and an object connected to the transducer is displaced in the longitudinal direction.

A transducer of this kind has the drawback that displacements of an object connected to the transducer in the x-direction, the y-direction and the longitudinal direction are coupled to one another. The displacement in the longitudinal direction is superposed on the displacement in the x-direction and the y-direction. Therefore, in the case of maximum displacement in the longitudinal direction, displacement in the x-direction and the y-direction is no longer possible. Furthermore, the coupling hampers accurate positioning and renders the driving of the transducer comparatively complex.

It is inter alia an object of the invention to provide an electro-mechanical transducer in which the coupling between the displacements is reduced.

To achieve this, an electro-mechanical transducer in accordance with the invention is characterized in that the outer electrode comprises a further conductor segment which is electrically isolated from the conductor segments in a longitudinal direction by a further insulating track, the inner electrode comprising at least two inner conductor segments which are electrically isolated from one another in the longitudinal direction by an inner insulating track.

When the outer electrode is provided with a further conductor segment and the inner electrode is subdivided into two inner conductor segments, application of a difference voltage across the further outer conductor segment and the oppositely situated inner conductor segment can produce a length variation which is uniform over the circumference of the element for the part of the element which is situated underneath the further outer conductor segment. A displacement in the x-direction and in the y-direction takes place under the influence of a voltage between the outer conductor segments and the inner conductor segment which is situated opposite the relevant outer conductor segments. A range in the x-direction and the y-direction is thus no longer dependent on the displacement in the longitudinal direction.

A preferred embodiment of an electro-mechanical transducer in accordance with the invention is characterized in that it comprises an equal number of inner and outer conductor segments, radial projections of inner insulating tracks on the outer side being coincident with the outer insulating tracks.

When the transducer is provided with an equal number of inner and outer conductor segments which are oppositely situated, voltages between inner and outer electrodes can be more accurately adjusted locally, cross-talk of voltages between the electrodes thus being reduced. In this preferred embodiment, two supply sources suffice for driving the displacement in the x-direction and the y-direction, as opposed to the known transducer which requires two pairs of supply sources of opposite sign for displacement in the x-direction and the y-direction.

A positioning device for a relative displacement of two objects with respect to one another, comprising an electro-mechanical transducer in accordance with the invention, is characterized in that the object connected to the positioning device is situated on the longitudinal axis of the piezo-electric element and outside said element.

When the object is arranged on the longitudinal axis of the element, the object rotates about the point of attachment when the element is driven in the x-direction or the y-direction. Thus, a relationship between a height variation of an end of the object, for example, a needle, and a displacement in the x-direction or the y-direction is simpler than in the known positioning device, in which the object is connected to a side of the transducer. The drive of the positioning device can thus be simplified.

An embodiment of a positioning device in accordance with the invention is characterized in that the objects comprise a first and a second glass fibre, the positioning device acting as a switch for optically coupling the first glass fibre, being connected to the electro-mechanical transducer, to the second glass fibre.

A positioning device in accordance with the invention can be used for switching light signals conducted by glass fibres. A glass fibre connected to the transducer can be pressed against another glass fibre and can be removed therefrom, for example so as to be pressed against again another glass fibre by the transducer. Switching frequencies of 1 kHz are feasible.

Further applications of a positioning device in accordance with the invention are found in the field of electron microscopy where an electron source or electron lenses in an electrical-optical system can be positioned by means of the positioning device.

Some embodiment of an electro-mechanical transducer and a positioning device in accordance with the invention will be described in detail hereinafter with reference to the accompanying drawing. Therein:
Figures 1a and 1b are an overall view and a plan view, respectively, of a known electro-mechanical transducer,
Figures 2a and 2b are an overall view and a plan view, respectively, of an electro-mechanical transducer in accordance with the invention,
Figures 3a and 3b show an embodiment of a positioning device in a scanning tunneling microscope,
Figures 4a and 4b show a further embodiment of a positioning device, and
Figure 5 shows a glass fibre switch.

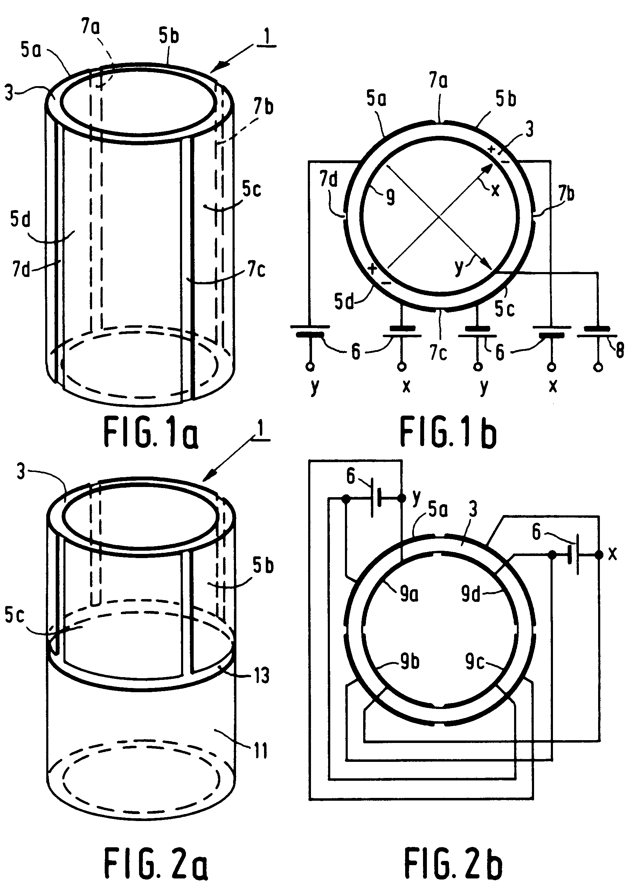

Figure 1a shows a known electro-mechanical transducer 1 which comprises a tubular piezo-electric element 3. The piezo-electric element 3, containing, for example a quartz crystal, Rochelle salt or barium titanate, is provided on an outer side with an electrode which is sub-divided into four conductor segments 5a, 5b, 5c and 5d. The outer conductor segments 5a-5d are electrically isolated from one another in a circumferential direction of the element 3 by tracks 7a-7d. Figure 1b is a plan view of the element 3. An inner electrode 9 is connected to an inner side of the element 3 and is concentric with the conductor segments 5a-5d. When a voltage is applied, using one of the four voltage sources 6, between one of the conductor segments 5a-5d and the inner electrode 9, the piezo-electric material situated underneath the relevant conductor segment contracts or expands in the longitudinal direction of the element 3. When a voltage is applied between oppositely situated outer conductor segments (5a and 5c or 5b and 5d), the length of oppositely situated sides of the element 3 changes, so that the element 3 is bent in an x-direction or an y-direction situated in a radial plane. By application of a voltage, using a voltage source 8, to the inner electrode 9, the length of the element 3 will uniformly change over the entire circumference, so that an object connected to the element 3 is displaced in a longitudinal direction. This displacement is superposed on the displacement in the x-direction and the y-direction. Displacements in the x-direction and the y-direction are also coupled. For example, when a difference voltage is applied between the conductor segments 5a and 5c, the tubular element 3 is bent about an y-axis. The y-axis shown in the figure retains its position, but the piezo-electric material on both sides of the y-axis expands and contracts, respectively. In the case of perfect symmetry of the piezo-electric element, the positive charge compensates for the negative charge on the conductor segments 5b and 5d. In the case of non-perfect symmetry, however, a charge is built up on the electrodes 5b and 5d, so that a displacement takes place in the y-direction. Because of capacitive cross-talk between the conductor segments, the charge built up in its turn influences the displacement in the x-direction.

Figure 2a shows an electro-mechanical transducer 1 in accordance with the invention whose outer electrode is provided with a further outer conductor segment 11. The further outer conductor segment 11 is electrically isolated from the conductor segments 5a-5d in the longitudinal direction by an insulating track 13. The insulating tracks 7a-7d and 13 may be provided in the electrode, for example mechanically or by way of etching. The inner electrode is also subdivided into two conductor segments by an insulating track on the inner side of the element 3, one part preferably being situated at the level of the conductor segments 5a-5d, the other part preferably being situated opposite the further outer conductor segment 11. When a difference voltage is applied between the further outer conductor segment 11 and the oppositely situated conductor segment of the inner electrode, a uniform length variation occurs over the circumference of the element 3, without influencing a range of displacement in the x-direction and the y-direction. When the inner conductor segment which is situated opposite the outer conductor segments for displacement in the x-direction and the y-direction is subdivided into further inner conductor segments as shown in Figure 2b, two voltage sources 6 suffice for driving the displacement in the x-direction and the y-direction. Capacitive cross-talk between the outer conductor segments is counteracted by subdividing the inner electrode into further conductor segments 9a, 9b, 9c and 9d. Compensation for displacements due to charge built up because of asymmetries of the element 3 is thus simplified.

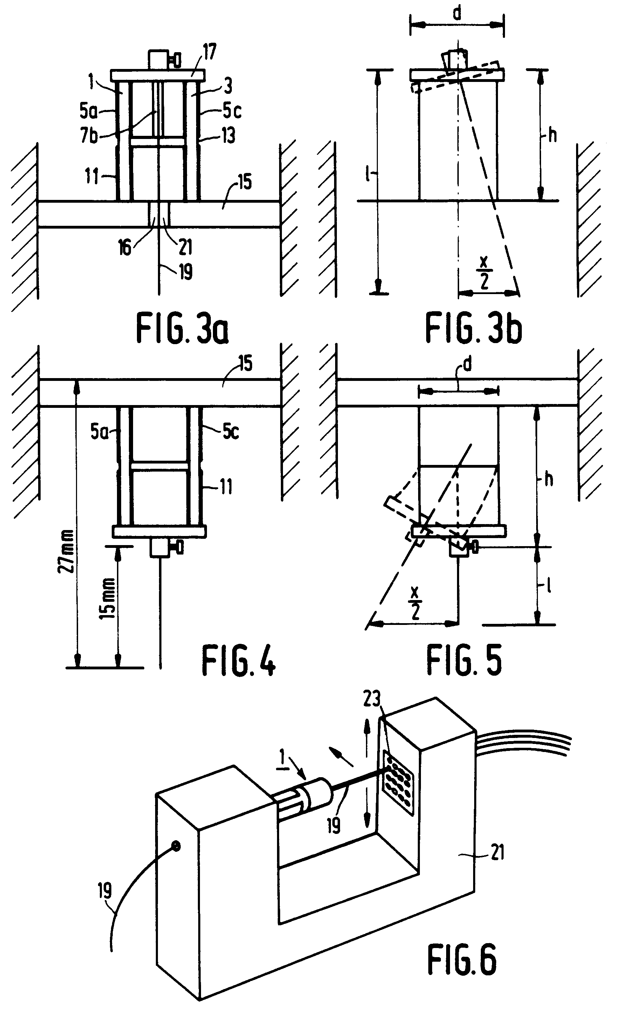

Figure 3a shows an embodiment of a positioning device in accordance with the invention in a scanning tunneling microscope. The transducer 1 is mounted on a rigid carrier 15 and comprises connection means 17 via which an object 19, in this case a current-conducting needle, is coupled to the element 3. Figure 3b shows how, under the influence of a difference voltage between the conductor segments 5a and 5c (with respect to the conductor segments on the inner side) the upper portion of the element 3 rotates because the side underneath the conductor segment 5a contracts and the side underneath the conductor segment 5c expands. The object 19 thus rotates about its point of attachment. A sensitivity of the element 3 amounts to, for example 4x10⁻¹⁰ m V⁻¹mm⁻¹ for a wall thickness of 1 mm. In the case of a voltage difference of from +500 V to -500 V between the conductor segment 11 and the oppositely situated inner conductor segment and a length h of the element 3, the conductor segment 11 extending over one half of the length, a range for the element in the longitudinal direction is given by: 2 500 Vx0.5xhx4x10⁻¹⁰V⁻¹mm⁻¹. For a length h of 12 mm, the range is 2.4 »m. Figure 3b shows that for an element having a diameter d the range X in the x-direction is given by: 0.5 X/l = 2.4 »m/d (0.5 d). For a diameter of 6.5 mm, the range X amounts to 44 »m. In order to prevent cross-talk between the inner conductor segments and the object 19, an electrical shield is preferably provided on the inner side of the element 3.

Figure 4a shows a further embodiment of a positioning device in accordance with the invention. Because the object 19 is situated entirely outside the element 3, shielding is not required. Figure 4b illustrates a displacement in de x-direction due to a change of length of the sides of the element 3. For the range X the following can be derived: 0.5 X/(1+0.5h) = 2.4 »m/d(0.5d). For a length 1 of 18 mm the range X amounts to 36 »m.

Figure 5 shows a positioning device in accordance with the invention in the form of a glass fibre switch. The transducer 1 is connected to a U-shaped base 21. The object 19 is formed by a glass fibre which is optically coupled to one of the glass fibres of a matrix of glass fibres 23 by way of the transducer 1. When the glass fibre 19 is switched, the transducer 1 retracts the glass fibre, subsequently moves it to a further glass fibre in the matrix, and presses the glass fibre 19 thereagainst. Switching frequencies of 1 kHz can thus be achieved.

## Claims

1. An electro-mechanical transducer, comprising a tubular piezo-electric element which is covered with an inner and an outer electrode over a length on an inner side and an outer side, respectively, which outer electrode comprises conductor segments which are electrically isolated from one another in a circumferential direction by insulating tracks, characterized in that the outer electrode comprises a further conductor segment which is electrically isolated from the conductor segments in a longitudinal direction by a further insulating track, the inner electrode comprising at least two inner conductor segments which are electrically isolated from one another in the longitudinal direction by an inner insulating track.

2. An electro-mechanical transducer as claimed in Claim 1, characterized in that it comprises an equal number of inner and outer conductor segments, radial projections of inner insulating tracks on the outer side being coincident with the outer insulating tracks.

3. An electro-mechanical transducer as claimed in Claim 1 or 2, characterized in that on the outer side the insulating tracks extend parallel to the longitudinal direction, an angular distance between two neighbouring insulating tracks on the outerside amounting to 90 degrees.

4. A positioning device for a relative displacement of two objects with respect to one another, which positioning device comprises an electro-mechanical transducer as claimed in any one of the preceding Claims, the electro-mechanical transducer being connected to one of the objects.

5. A positioning device as claimed in Claim 4, characterized in that the object connected to the positioning device is situated on the longitudinal axis of the tubular piezo-electric element outside of said element.

6. A positioning device as claimed in Claim 4 or 5, characterized in that the objects comprise a first and a second glass fibre, the positioning device acting as a switch for optically coupling the first glass fibre, being connected to the electro-mechanical transducer, to the second glass fibre.

7. A positioning device as claimed in Claim 6, characterized in that the second glass fibre forms part of a matrix consisting of several glass fibres.

8. A positioning device as claimed in Claim 4 or 5, characterized in that the object connected to the transducer comprises an electron source in an electron-optical system.

9. A positioning device as claimed in Claim 4 or 5, characterized in that the object connected to the transducer comprises a current-conducting needle in a scanning tunneling microscope.

## Patentansprüche

1. Elektromechanischer Wandler mit einem rohrförmigen piezoelektrischen Element, das über eine Länge an einer Innenseite und an einer Außenseite mit einer inneren und einer äußeren Elektrode bedeckt ist, wobei die äußere Elektrode Leiterabschnitte enthält, die in einer Umfangsrichtung mittels Isolierbahnen voneinander elektrisch getrennt sind, dadurch gekennzeichnet, daß die äußere Elektrode einen zusätzlichen Leiterabschnitt enthält, der in einer Längsrichtung durch eine zusätzliche Isolationsbahn von den Leiterabschnitten elektrisch getrennt ist, wobei die innere Elektrode wenigstens zwei innere Leiterabschnitte enthält, die in der Längsrichtung durch eine innere Isolierbahn elektrisch voneinander getrennt sind.

2. Elektromechanischer Wandler nach Anspruch 1, dadurch gekennzeichnet, daß er mit einer untereinander gleichen Anzahl innerer und äußerer Leiterabschnitte versehen ist, wobei radiale Projektionen von inneren Isolierbahnen auf der Außenseite mit den äußeren Isolierbahnen zusammenfallen.

3. Elektromechanischer Wandler nach Anspruch 1 oder 2, dadurch gekennzeichnet, daß auf der äußeren Seite die Isolierbahnen sich parallel zur Längsrichtung erstrecken, wobei ein Winkelabstand zwischen zwei benachbarten Isolierbahnen auf der Außenseite 90° beträgt.

4. Positioniereinrichtung für eine relative Verschiebung von Zwei Gegenständen gegeneinander, die mit einem elektromechanischen Wandler nach einem oder mehreren der vorangehenden Ansprüche versehen ist, wobei der elektromechanische Wandler mit einem der Gegenstände verbunden ist.

5. Positioniereinrichtung nach Anspruch 4, dadurch gekennzeichnet, daß der mit der Positioniereinrichtung verbundene Gegenstand auf der Längsachse des piezoelektrischen Elements und außerhalb dieses Elements liegt.

6. Positioniereinrichtung nach Anspruch 4 oder 5, dadurch gekennzeichnet, daß die Gegenstände eine erste und eine zweite Glasfaser enthalten, wobei die Positioniereinrichtung als Schalter zum optischen Koppeln der ersten mit dem elektromechanischen Wandler verbundenen Glasfaser mit der zweiten Glasfaser enthält.

7. Positioniereinrichtung nach Anspruch 6, dadurch gekennzeichnet, daß die zweite Glasfaser einen Teil einer aus mehreren Glasfasern bestehenden Matrix bilden.

8. Positioniereinrichtung nach Anspruch 4 oder 5, dadurch gekennzeichnet, daß der mit dem Wandler verbundene Gegenstand eine Elektronenquelle in einem elektronenoptischen System enthält.

9. Positioniereinrichtung nach Anspruch 4 oder 5, dadurch gekennzeichnet, daß der mit dem Wandler verbundene Gegenstand eine stromleitende Nadel in einem Abtast-Tunnelungsmikroskop enthält.

## Revendications

1. Transducteur électromécanique, comprenant un élément piézo-électrique tubulaire dont les parois intérieure et extérieure sont respectivement revêtues, sur une longueur, d'une électrode intérieure et d'une électrode extérieure, l'électrode extérieure comprenant des segments conducteurs électriquement isolés les un des autres dans le sens circonférentiel par des pistes isolantes, caractérisé en ce que l'électrode extérieure comporte un segment conducteur supplémentaire électriquement isolé, dans le sens longitudinal, des autres segments conducteurs par une piste isolante supplémentaire, l'électrode intérieure comprenant au moins deux segments conducteurs intérieurs électriquement isolés les uns des autres, dans le sens longitudinal, par une piste isolante intérieure.

2. Transducteur électromécanique selon la revendication 1, caractérisé en ce qu'il comprend un nombre identique de segments conducteurs intérieurs et extérieurs, les projections radiales des pistes isolantes intérieures sur le côté extérieur coïncidant avec les pistes isolantes extérieures.

3. Transducteur électromécanique selon l'une des revendications 1 ou 2, caractérisé en ce que, sur le côté extérieur, les pistes isolantes s'étendent parallèlement à au sens longitudinal, une distance angulaire entre deux pistes voisines situées sur le côté extérieur étant de 90°.

4. Dispositif de positionnement pour le déplacement relatif de deux objets l'un par rapport à l'autre, dispositif qui comprend un transducteur électromécanique selon l'une des revendications précédentes, le transducteur électromécanique étant relié à l'un des objets.

5. Dispositif de positionnement selon la revendication 4, caractérisé en ce que l'objet relié au dispositif de positionnement est situé sur l'axe longitudinal de l'élément piézo-électrique tubulaire, en dehors dudit élément.

6. Dispositif de positionnement selon l'une des revendications 4 ou 5, caractérisé en ce que l'objet comporte une première et une seconde fibre optique, le dispositif de positionnement agissant en tant que commutateur pour le couplage optique de la première fibre optique, reliée au transducteur électromécanique, à la seconde fibre optique.

7. Dispositif de positionnement selon la revendication 6, caractérisé en ce que la seconde fibre optique fait partie d'une matrice constituée de plusieurs fibres optiques.

8. Dispositif de positionnement selon la revendication 4 ou 5, caractérisé en ce que l'objet relié au transducteur comprend une source d'électrons d'un système optoélectronique.

9. Dispositif de positionnement selon la revendication 4 ou 5, caractérisé en ce que l'objet relié au transducteur comprend une aiguille conductrice de courant d'un microscope de balayage en tunnel.
